(19)

Europäisches
Patentamt
European
Patent Office
Office européen
des brevets

(11) **EP 2 541 776 A1**

(12) **EUROPEAN PATENT APPLICATION**

(43) Date of publication:
**02.01.2013 Bulletin 2013/01**

(51) Int Cl.:
*H03M 1/74* (2006.01)          *H04L 27/36* (2006.01)

(21) Application number: **11171905.0**

(22) Date of filing: **29.06.2011**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(71) Applicant: **IMEC
3001 Leuven (BE)**

(72) Inventor: **Ingels, Mark
3370 Boutersem (BE)**

(74) Representative: **Mackett, Margaret Dawn et al
Gevers Patents
Holidaystraat 5
1831 Diegem (BE)**

(54) **Radio frequency modulators**

(57)     Described herein is a direct digital radio frequency modulator (1010) in which out of band quantisation noise is filtered directly at radio frequency. The modulator (1010) comprises a plurality of modulator elements (1012, 1014, 1016, 1018) each having a voltage bias transistor (1050). The transistor (1050) is tuned in accordance with finite impulse response filter coefficients. A pair of switches (EN0(1), RFin0, EN90(1), RFin90, EN180(1), RFin180, EN270(1), RFin270) is provided for each input phase. The RF signals are spaced apart from one another in accordance with a duty cycle related to the number of input phases.

Fig. 10

**Description**

Field of the Invention

The present invention relates to direct digital radio frequency modulators, in particular direct digital radio frequency modulators having reduced quantisation noise in chosen frequency bands.

Background to the Invention

In modern communication systems, exacting requirements are imposed on transmitters. Such transmitters have to combine the requirements of radio frequency (RF) bandwidth, linearity and out-of-band noise whilst maintaining high efficiency. In addition, with the development of new nanometre CMOS technologies, these transmitters should also be readily scalable with the lowest possible analogue content.

In a traditional direct up-conversion transmitter, a digital-to-analogue-converter (DAC) and a low-pass filter are used at baseband followed by an analogue up-conversion to RF. The aliases and the quantisation noise which are present in the output of the DAC are filtered with the low-pass filter at baseband. The resulting signal is then up-converted to the desired RF frequency in a mixer and further amplified by a power amplifier.

US-B-7528754 describes a bandpass Sigma-Delta Modulator with a semi-digital FIR reconstruction filter for RF use. The FIR transforms the oversampled single-bit digital input stream to a bandpass response centred at a sampling frequency. The DAC architecture embeds an up-conversion mixer inside the DAC and takes advantage of the FIR to provide out-of-band quantisation noise filtering at RF. In one embodiment, a current-steering DAC is implemented by an array of individually switchable current sources, the current sources being switchable in response to a control input signal. Current source outputs are combined to yield a total current that is proportional to the number of switched-on current sources.

Summary of the Invention

It is therefore an object of the present invention to provide a DDRM transmitter architecture which is simple with low power consumption and still reduces aliases and quantisation noise.

In accordance with a first aspect of the present invention, there is provided a radio frequency modulator comprising:

> an input to which an input signal is applied;
> at least one modulator element connected to the input and arranged for modulating the input signal to form a modulated output signal; and
> an output connected to each modulator element and outputting the modulated output signal;
> characterised in that each modulator element comprises a plurality of first switches, each first switch being switched in accordance with a multi-phase input signal to produce a modulated output signal.

In preferred embodiments, each modulator element further comprises a plurality of second switches for providing enable signals that operate in conjunction with the plurality of the first switches to produce the modulated output signal, each phase of the multi-phase input signal having a first switch and a second switch associated therewith.

It is preferred that each modulator element further comprises a bias control for controlling the output signal produced by the modulator element, e.g. the level of the output signal (amplitude, size, ...).

In one embodiment of the invention, the multi-phase input signal comprises a four-phase input signal. This provides a 25% duty cycle.

In another embodiment, a plurality of modulator elements is provided and the modulated output signal produced by each modulator element is summed to form the output modulated signal.

In accordance with another aspect of the present invention, there is provided a radio frequency transmitter comprising at least one radio frequency modulator as described above, and wherein the modulator elements together form at least one finite impulse response filter.

Additionally, a plurality of radio frequency modulators, and a delay circuit for each radio frequency modulator after the first, is provided, an enable signal being provided for a subsequent radio frequency modulator through its associated delay circuit.

In one embodiment, at least two radio frequency modulators are provided and each bias control operates in accordance with finite impulse response coefficients. A multi-phase radio frequency generator may be provided.

In one embodiment, four radio frequency modulators are provided and the multi-phase radio frequency generator comprises a four-phase radio frequency generator.

The radio frequency transmitter may further comprise a radio frequency multi-phase local oscillator (LO) generator. In addition, a decoding circuit may be provided for decoding input signals. In one embodiment, the decoding circuit decodes in-phase and quadrature-phase signals.

Brief Description of the Drawings

For a better understanding of the present invention, reference will now be made, by way of example only, to the accompanying drawings in which:-

Figure 1 illustrates a schematic diagram of a conventional I/Q transmitter;
Figure 2 illustrates a schematic diagram of a conventional polar transmitter;
Figure 3 illustrates a schematic diagram of a DDRM transmitter;
Figure 4 illustrates a schematic diagram showing the effect of noise and aliases for the transmitters shown in Figures 1 and 3;
Figure 5 illustrates is a schematic diagram showing the operational concept of a DDRM;
Figure 6 illustrates a schematic diagram of a DDRM;
Figure 7 illustrates a graph showing the resultant drain current for the DDRM of Figure 6;
Figure 8 illustrates a schematic drawing showing the efficiency problem for I/Q modulation;
Figure 9 illustrates a schematic diagram of a DDRM in accordance with the present invention;
Figure 10 illustrates a graph showing the drain current waveform for the DDRM of Figure 9;
Figure 11 illustrates the efficiency in the complex domain for the DDRM of Figure 9;
Figure 12 illustrates a schematic diagram of a FIR DDRM in accordance with the present invention;
Figure 13 illustrates a schematic diagram of a third order FIR digital transmitter;
Figures 14 and 15 illustrate possible FIR spectra obtained for $D^{-1}$ and $D^{-0.5}$ respectively and pure amplitude modulation;
Figure 16 illustrates a schematic diagram of a circuit for FIR direct to RF transmitter in accordance with the present invention;
Figure 17 illustrates a block diagram of a decoding circuit;
Figure 18 illustrates a schematic diagram of a chip layout; and
Figure 19 illustrates the effect on the noise floor with and without FIR.

Description of the Invention

The present invention will be described with respect to particular embodiments and with reference to certain drawings but the invention is not limited thereto. The drawings described are only schematic and are non-limiting. In the drawings, the size of some of the elements may be exaggerated and not drawn on scale for illustrative purposes.
Cognitive-radio transmitters have to satisfy the requirements for multiple communication standard such as large range of output power levels, different carrier frequencies, low quantisation noise in the receiver bands and high efficiency with high output power. Many challenges exist when implementing such cognitive-radio transmitters, and they are required to be able to transmit the signals for multiple communication standards having: different bandwidths; different peak-to-average-power ratios (PAPR) and high PAPR; different resolutions to satisfy the required error vector magnitudes (EVM) for each communication standard; a wide range of power levels; different carrier frequencies; different emission masks; and different receiver noise limitations. In addition, suitable efficiency and small chip area for the circuit to be integrated with the digital part of the transmitter, namely, scalability.
Although the present invention has been described with reference to cognitive-radio transmitters, it will readily be appreciated that the invention is not limited to the use in such transmitters and can be used in all direct digital radio transmitters to reduce quantisation noise in a chosen band, for example a receiver band.
In a direct digital RF modulator (DDRM), the DAC, mixer and the power amplifier functions are combined in a single block. However, the DAC signal is no longer filtered and as a result quantisation noise and aliases reach the output unattenuated. These unwanted emissions are inherent to the DDRM.
For frequency division duplexing (FDD) standards, when transmitter and receiver are working concurrently, very strict noise requirements are imposed for the transmitter noise at the receiver frequency. If these requirements have to be met by increasing the resolution and the oversampling, this results in a greatly increased complexity and power consumption.
As the toughest noise requirements are specifically applied to the receiver frequency, it is an option to filter the quantisation noise locally around the receiver frequencies. This can be achieved using a finite impulse response (FIR) filter. A FIR filter comprises a series of subsequent gain elements with a delay element between adjacent elements in the series. Input data is shifted from one gain element to the next gain element. The individual output from each gain element is added together with the output from all the other gain elements to provide the output. By changing the coefficient of each transmitter or the RF current contribution value of each transmitter, it is possible to relocate the quantisation noise notch to be in the receiver band. However, the FIR function only affects quantisation noise and the depth of the filter is limited by physical noise of the circuit, phase noise from the local oscillator or thermal noise from the circuits.

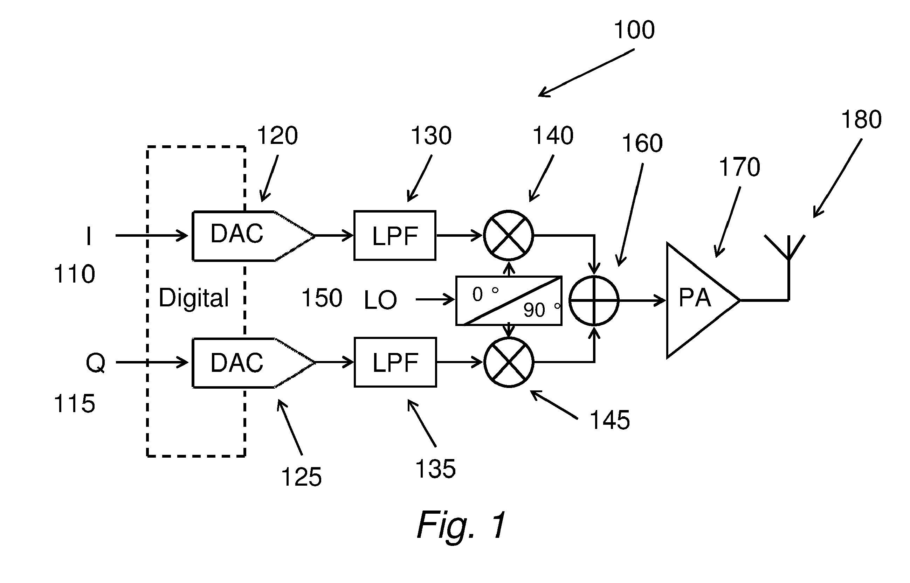

Figure 1 illustrates a conventional I/Q transmitter arrangement 100 in which digital I and Q signals 110, 115 are converted to analogue signals by respective DACs 120, 125, and filtered by respective low pass filters (LPFs) 130, 135. The filtered signals are up-converted by being mixed in mixers 140, 145 with signals from a local oscillator (LO) 150. The LO signal supplied to the mixer 140 is 0° and that supplied to the mixer 145 is at 90°. The up-converted signals are then summed in 160. The signals are then passed via a power amplifier (PA) 170, to an antenna 180 for transmission.

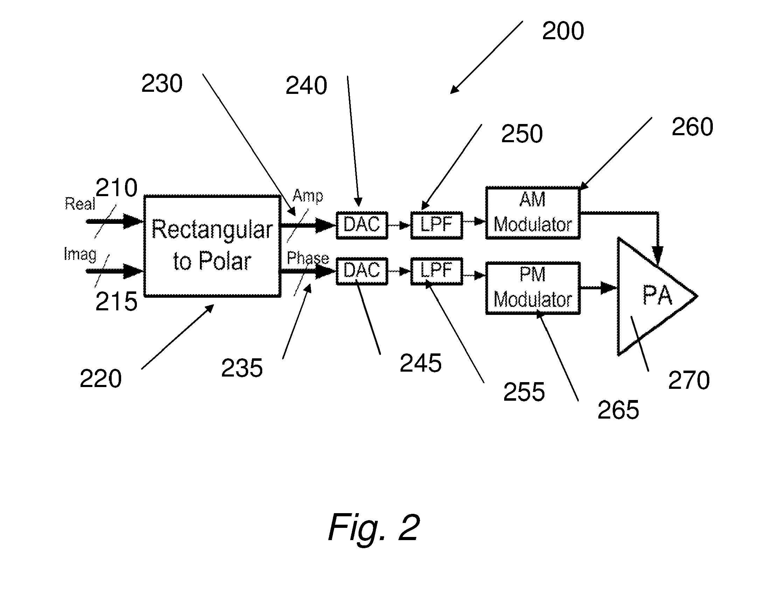

Figure 2 illustrates a conventional polar transmitter arrangement 200 in which real and imaginary components 210, 215 are transformed from Cartesian or rectangular to polar in a converter 220. Outputs 230, 235 from the converter 220 correspond to amplitude and phase respectively. The outputs 230, 235 are converted to analogue signals in DACs 240, 245 before being filtered by LPFs 250, 255. The filtered signals are passed to respective amplitude and phase modulators 260, 265 before passing to a PA 270.

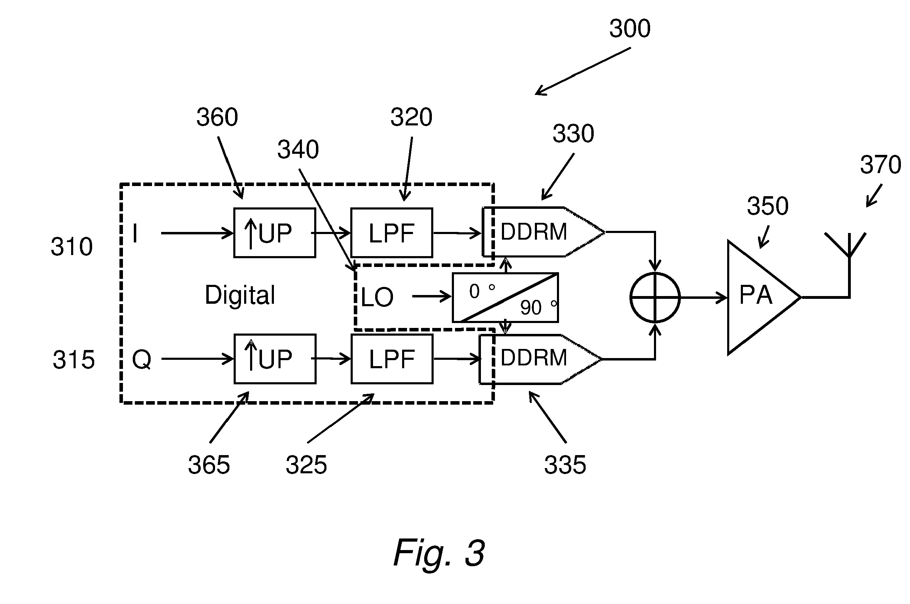

In Figure 3, a DDRM transmitter arrangement 300 is shown in which I and Q signals 310, 315 are digitally upsampled in 360, 365 and low-pass filtered in digital LPFs 320, 325 before being passed to digital-to-RF converters (DDRMs) 330, 335 where the signals are mixed with LO signals from a LO 340 as shown. The RF signals are summed and passed to PA 350, before being passed to antenna 370 for transmission. Here, the filtering takes place in the digital domain prior to the direct conversion to RF.

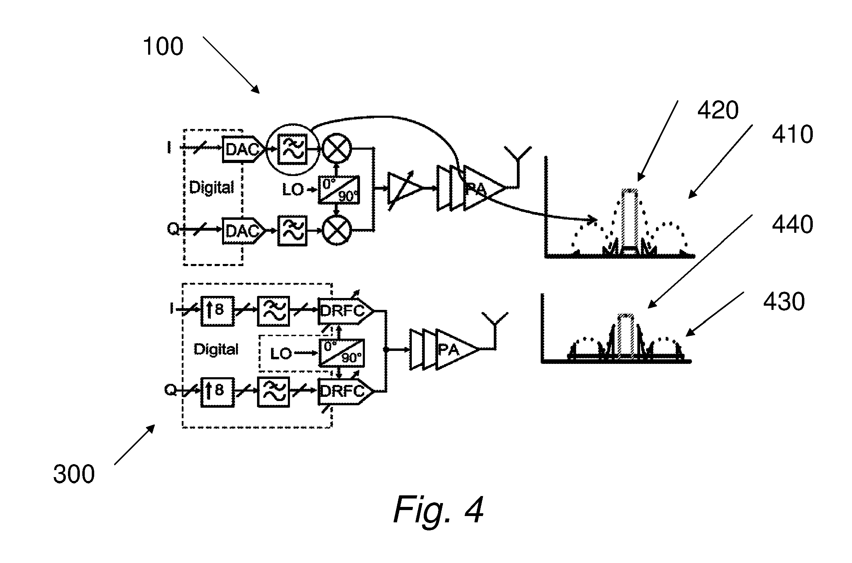

The DDRM transmitter arrangement 300 provides more bandwidth flexibility and has lower power consumption than the conventional polar transmitter arrangement 200. This provides a higher bandwidth before the signals are recombined in amplitude and phase. In particular, the DDRM arrangement provides easier digital modulation, better scalability, higher RF bandwidth potential, and lower area, with no synchronisation issues. However, the DDRM arrangement 300 is not as good when considering quantisation noise and DAC aliases. Efficiency is reduced by the IQ recombination. These disadvantages are due to the absence of an analogue LPF that suppresses the DAC aliases and the out-of-band quantisation noise, and the I/Q combination that adversely affects efficiency. This is illustrated in Figure 4.

In Figure 4, for the conventional I/Q transmitter arrangement 100, it can readily be appreciated that the LPFs 130, 135 provide filtering of the aliases and the quantisation noise as shown by the graph 410. The RF signal after up-conversion is shown at 420. For the DDRM transmitter arrangement 300, as shown in graph 430, the aliases and the quantisation noise are also up-converted as shown with the RF signal being shown at 440.

Graphs 410 and 430 are not shown on the same scale and the height of the respective RF signals 420 and 440 shown effectively are the same.

Removing the analog LPF that suppresses quantisation noise, results in upconverted noise in the receiver band and consequently degrades the SNR of the received signal. By increasing the modulator resolution and the modulator sampling frequency (increase over sampling frequency (OSR)), the problem of quantisation noise and DAC aliases can be reduced.

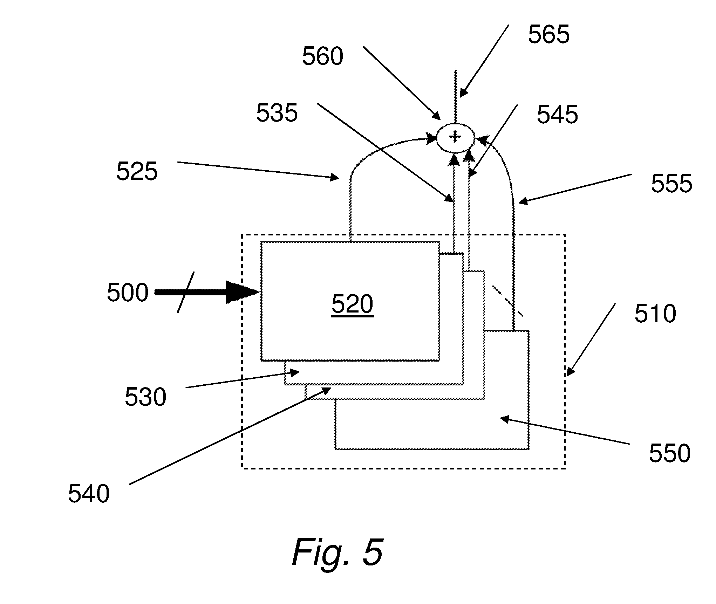

In Figure 5, the principle of DDRM is shown. Here, a modulated digital input signal 500 is input to a modulator 510 that comprises a plurality of modulator elements 520, 530, 540, 550. The modulated digital input signal 500 may comprise a data or byte stream. Each modulator element 520, 530, 540, 550 comprises a mixer and PA (not shown), the current output 525, 535, 545, 555 from each modulator element 520, 530, 540, 550 being summed in a summer 560 to provide an analogue output current 565. Digital modulation is applied by employing a varying number of modulation elements 520, 530, 540, 550 depending on the value of input signal 500. This is done by switching the modulation elements 520, 530, 540, 550 ON and/or OFF. However, as there is no analogue LPF, signal-aliases and quantisation noise are introduced outside the transmit band, including into the receiver band as described with reference to Figure 4 above.

Although four modulation elements 520, 530, 540, 550 are shown, it will be appreciated that any suitable number of modulator elements can be provided, for example, $2^N$-1 modulator elements, in accordance with the resolution of the digital signals. For example, in one embodiment where a resolution of 8 bits is used, there may be 127 modulator elements. It is to be noted, however, that the chosen resolution may provide a compromise between performance and complexity as the number of digital levels, that is, the resolution, is related to complexity. In addition, there are other ways of determining the number of modulator elements and the above example is given by way of example only.

Whilst a FIR DDRM can be used to overcome the problems associated with DAC aliases and quantisation noise in the receiver band, different mixer and current control options may be provided. For example, low power may be generated and an external PA used to boost the power for transmission. By including the PA in an integrated transmitter, efficiency needs to be increased and this is done by using the switching behaviour of the LO signal so that the PA has either Class B or Class C switching.

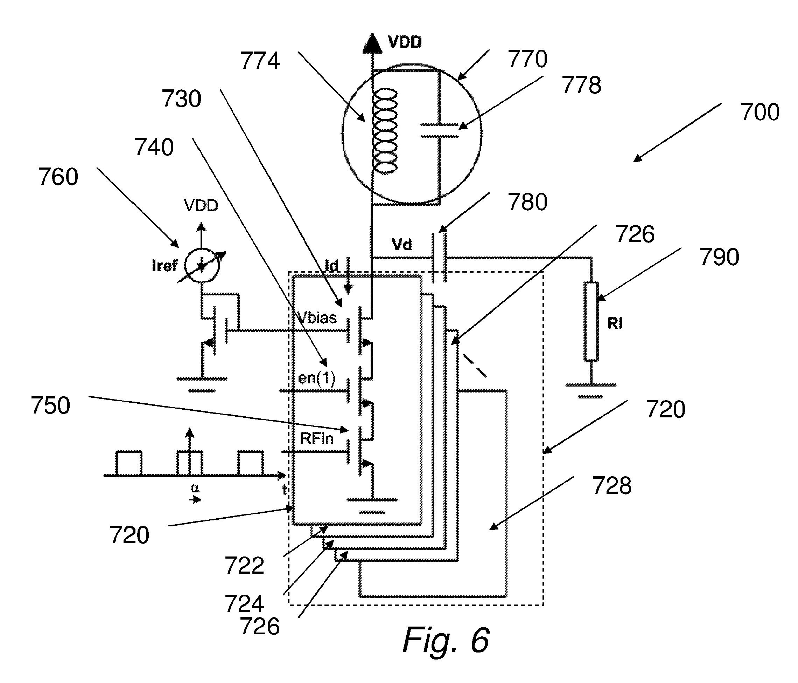

In accordance with the present invention, a DDRM transmitter arrangement 700 is shown in Figure 6. A modulator 710 comprises a plurality of modulator elements 720, 722, 724, 726, 728. Although five modulator elements are shown, there may be any number of modulator elements. In one embodiment, there may be $2^N$-1 modulator elements as described with reference to Figure 5 above.

For each modulator element 720, 722, 724, 726, 728, three transistors 730, 740, 750 are provided. Upper transistor 730 comprises a thick-gate MOSFET which is used to control the output current using a current mirror. Lower transistors 740, 750 comprise switches where transistor 720 is an RF switch, and transistor 730 provides an enable signal. In addition, a reference current 760 is provided to control the gain of the element through transistor 730. Here, transistor 730 acts as a bias control. Shorted harmonics filter 770 comprising an inductor 774 and a capacitor 778 are provided. In addition, a DC blocking capacitor 780 is provided together with a load 790.

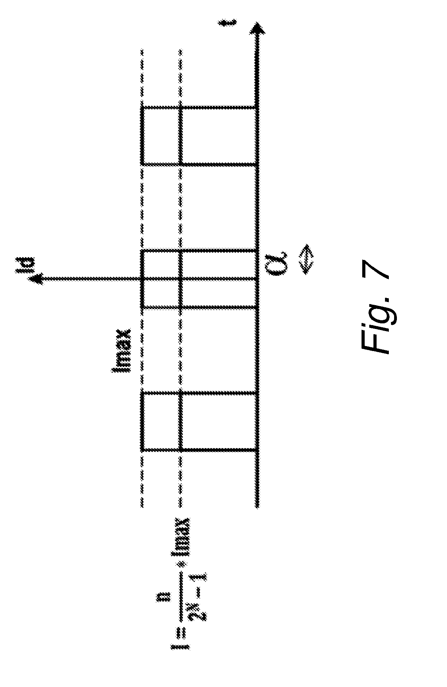

The transmitter arrangement 700 produces a drain current as shown in Figure 7. In Figure 7, the effect of changing the conduction angle on efficiency is also shown.

The equations below are valid for an example according to the invention. The general lines are universal, but e.g. the max current formula may depend on the way the cells are scaled. The example is N bit with unscaled cells, so max $2^N$ -1.

When all the cells are in ON state, the maximum current, $I_{max}$, in terms of the cell current, $I_{cell}$, is given by:

$$I_{max} = (2^N - 1) * I_{cell} \qquad (1)$$

The drain current, $I$, when n cells are in ON state is given by:

$$I = n * I_{cell} \qquad (2)$$

The maximum DC current, $I_{dc}$, of the resultant drain current, in terms of conduction angle, $\alpha$, is given by:

$$I_{dc} = \frac{\alpha * I_{max}}{\pi} \qquad (3)$$

The maximum current amplitude, $I_1$, of the fundamental Fourier component is given by:

$$I_1 = \frac{2 * I_{max} * \sin(\alpha)}{\pi} \qquad (4)$$

As shown in Figure 6, the shorted harmonics 770 absorb all the harmonics, the fundamental current component ($I_1$) goes to the load. The optimum load resistance, $R_{opt}$, is defined as:

$$R_{opt} = \frac{\pi * V_{dc}}{2 * I_{max} * \sin(\alpha)} \qquad (5)$$

The output power, $P_{out}$, is given by:

$$P_{out} = \frac{V_{dc} * \sin(\alpha) * I_{max}}{\pi} \tag{6}$$

The consumed power, $P_{dc}$, is given by:

$$P_{dc} = \frac{V_{dc} * \alpha * I_{max}}{\pi} \tag{7}$$

The maximum efficiency, $eff_{max}$, is given by:

$$eff(\max) = \frac{\sin(\alpha)}{\alpha} \tag{8}$$

Equation (8) shows that if the conduction angle ($\alpha$) is zero, the maximum efficiency will be 100%, while the output power will be zero as shown in equation (6). A value needs to be chosen for $\alpha$ that provides a compromise between efficiency and output power. On the other hand, we should test the linearity of this transmitter. The drain current with n ON elements is

$$I = \frac{n * I_{max}}{(2^N - 1)} \tag{9}$$

From equation (4) and equation (9), the fundamental Fourier current is

$$I_1 = \frac{2 * I_{max} * \sin(\alpha) * n}{\pi * (2^N - 1)} \tag{10}$$

From equation (10), the inherent linearity of the system can be deduced as the fundamental Fourier current is linearly proportional to n (number of ON elements).

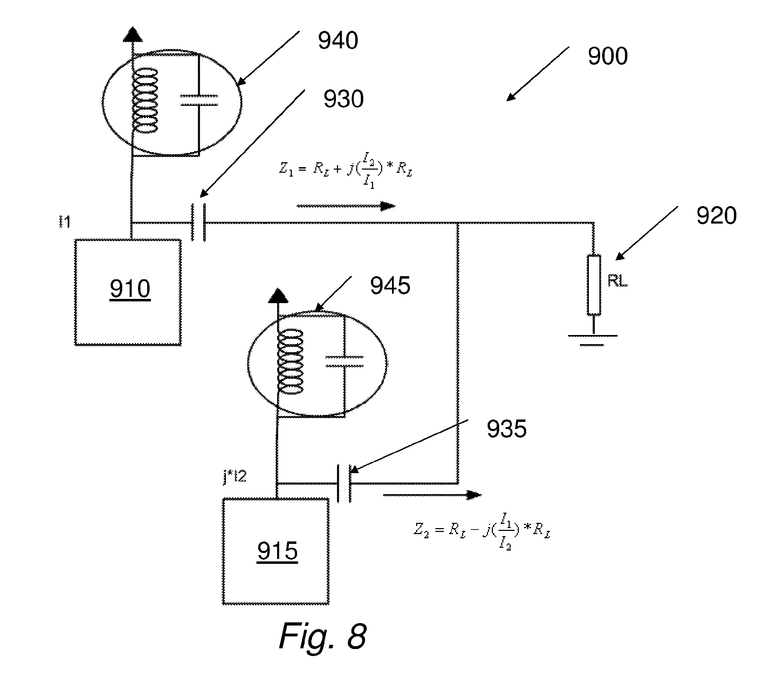

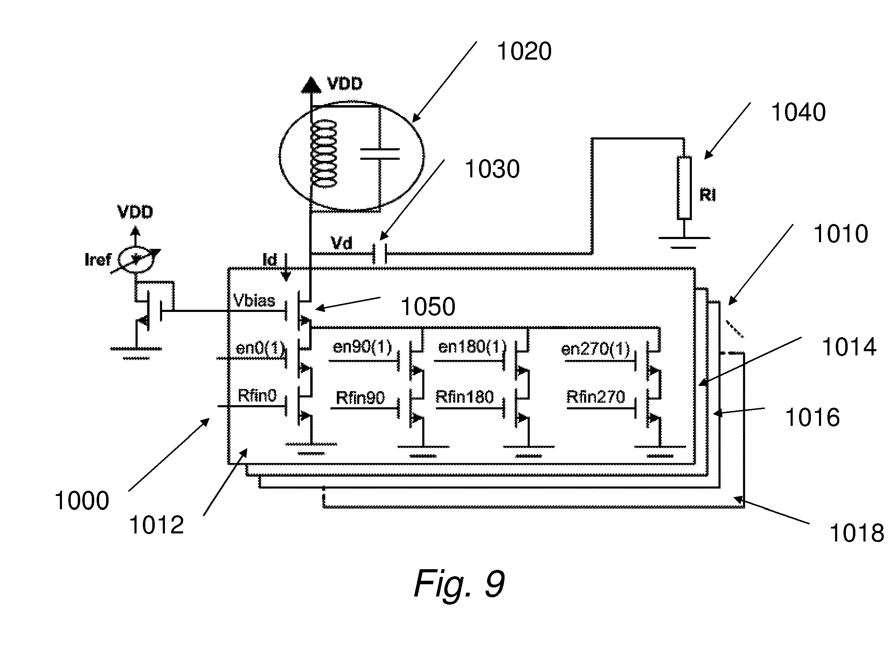

Figure 8 illustrates the efficiency problem in terms of I and Q components. A I/Q transmitter arrangement 900 includes an in-phase amplifier 910 and a quadrature amplifier 915 connected to a load 920 via DC blocking capacitors 930, 935. Harmonics shorting filters 940, 945 are also provided as shown. By directly summing the in-phase (I) and quadrature-phase (Q) currents, the optimum load impedance of the I current is changed by the Q current as imaginary components are introduced. Similarly, the Q current is changed by the I current. This results in a reduced efficiency during modulation. By modifying the transmitter modulator element to contain four RF phases with 25% duty cycle, a more efficient cell is provided in accordance with the present invention, as shown in Figure 9. Such a modulator element improves efficiency as it switches between Class-B and Class-C.

In Figure 9, a DDRM transmitter arrangement 1000 is shown. A modulator 1010 is shown that comprises a plurality of modulator elements 1012, 1014, 1016, 1018. Again, although only four modulator elements are shown, there may be any number of modulator elements, for example $2^N$-1 modulator elements. Shorted harmonics filter 1020 and a DC blocking capacitor 1030 are also provided, the capacitor 1030 being connected in series with a load 1040.

Each modulator element 1012, 1014, 1016, 1018 comprises a common thick oxide bias transistor 1050, that controls the gain of the modulator element and protects low voltage switches formed by eight active transistors. The eight switches comprise four RF switches RF0, RF90, RF180, RF270, and four IQ digitally modulating enable switches EN0, EN90, E180, EN270, an RF switch and an IQ digitally modulating enable switch being required for each phase.

Gain which determines the coefficients of the FIR function is controlled through a current mirror. The RF signals are designed to be 90° apart from one another with a 25% duty cycle.

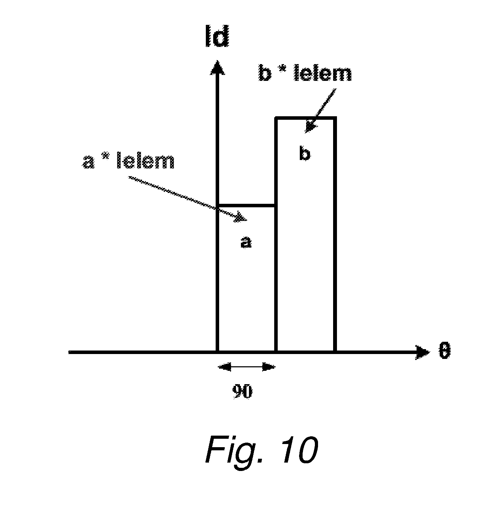

To transmit in the first quadrant, EN180 and EN270 are switched off for all modulator elements. However, EN0 and EN90 of the cells are switched with respect to the transmitted code in the first quadrant. To transmit the code 'a+jb', EN0 for 'a' elements and EN90 for 'b' elements are switched on. If 'N' represents the number of modulator elements, EN0 for 'N-a' modulator elements and EN90 for 'N-b' modulator elements are switched off. Therefore the current drain is as shown in Figure 10.

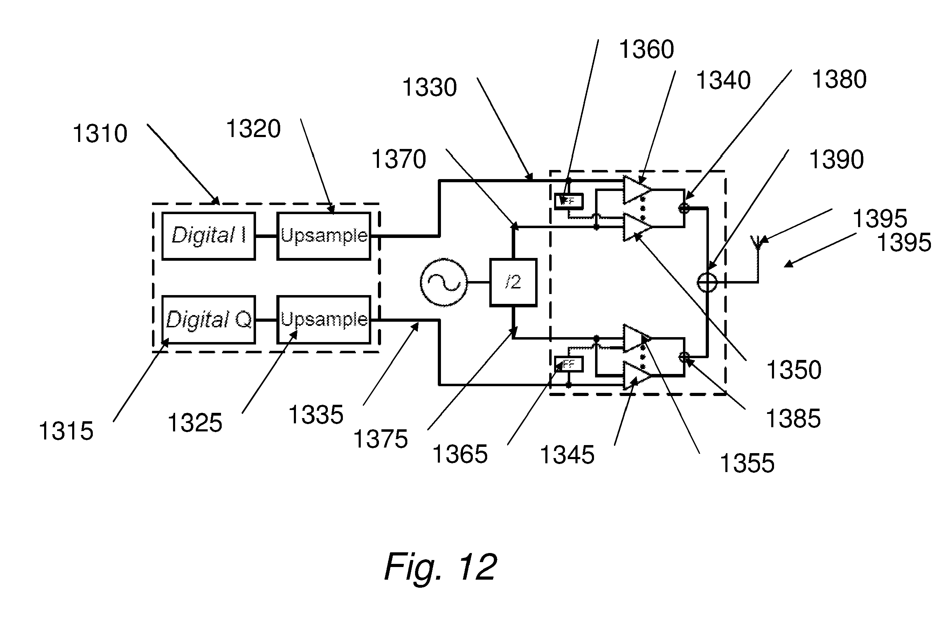

The ideal drain efficiency of the modulator as a function of 'a' and 'b' is shown in Figure 12. When 'a' and 'b' are at maxima, the resulting current has a 50% duty cycle. When 'a' is at a maximum and 'b' is at zero or vice versa, the resulting current is 25% duty cycle.

The DDRM topology is therefore able to perform modulation in all quadrants with relatively high efficiency and high output power.

Although the embodiment described above with reference to Figure 9 illustrates a four-phase input signal with a duty cycle of 25%, it will be appreciated that a multi-phase input signal can be used with an appropriate duty cycle.

The drain current waveform for first quadrant modulation is shown in Figure 10, but it will be appreciated that each quadrant is similar. If a is the number of on cells for the first phase, and b is the number of on cells for the second phase, $a_{max}$ is obtained when all the available cells are in an ON state. Similarly, $b_{max}$, is obtained when all available cells are in an ON state. The element current is $I_{elem}$, and the fundamental component real current value, $Id_{real}$, is

$$Id_{real} = \frac{1}{\pi} \int_0^\pi (a * I_{elem} * \cos(\theta - \frac{\pi}{4}))d\theta + \frac{1}{\pi \int_{\pi/2}^\pi (b * I_{elem} * \cos(\theta - \frac{\pi}{4}))d\theta} \qquad (11)$$

The fundamental component imaginary current value, $ID_{imag}$, is

$$Id_{imag} = \frac{1}{\pi} \int_0^{\pi/2} (a * I_{elem} * \sin(\theta - \frac{\pi}{4}))d\theta + \frac{1}{\pi} \int_{\pi/2}^\pi (b * I_{elem} * \sin(\theta - \frac{\pi}{4}))d\theta \qquad (12)$$

After integration, the real and imaginary components of the fundamental current are

$$Id_{real} = \frac{a * I_{elem} * \sqrt{2}}{\pi} \qquad (13)$$

$$Id_{imag} = \frac{b * I_{elem} * \sqrt{2}}{\pi} \qquad (14)$$

From equations (13) and (14), it can be concluded that the system has inherent linearity, since the real current component is proportional to a, and the imaginary current component is proportional to b. In order to determine a formula for efficiency formula, the magnitude, $Id_{mag}$, of the fundamental component and the DC components, $I_{dc}$, needs to be obtained. They are respectively:

$$Id_{mag} = \frac{\sqrt{(a^2 + b^2)} * I_{elem} * \sqrt{2}}{\pi} \qquad (15)$$

$$I_{dc} = \frac{I_{elem} * (a + b)}{4} \qquad (16)$$

For maximum power and maximum efficiency, the optimum load resistance, $R_{L(optimum)}$, is:

$$R_{L(optimum)} = \frac{\pi * V_{dc}}{2 * N * I_{elem}} \qquad (17)$$

The output power, $P_{out}$, is:

$$P_{out} = \frac{I_{elem} * (a^2 + b^2) * V_{dc}}{2 * \pi * N} \qquad (18)$$

The DC power, $P_{vdd}$, is

$$P_{vdd} = V_{dc} * I_{dc} = \frac{V_{dc} * I_{elem} * (a + b)}{4} \qquad (19)$$

The drain efficiency, $\eta$, is

$$\eta = \frac{2 * (a^2 + b^2)}{\pi * N * (a + b)}$$
$$\eta(a = N, b = N) = 63.6\% \qquad (20)$$
$$\eta(a = N, b = 0) = \eta(a = 0, b = N) = 63.6\%$$

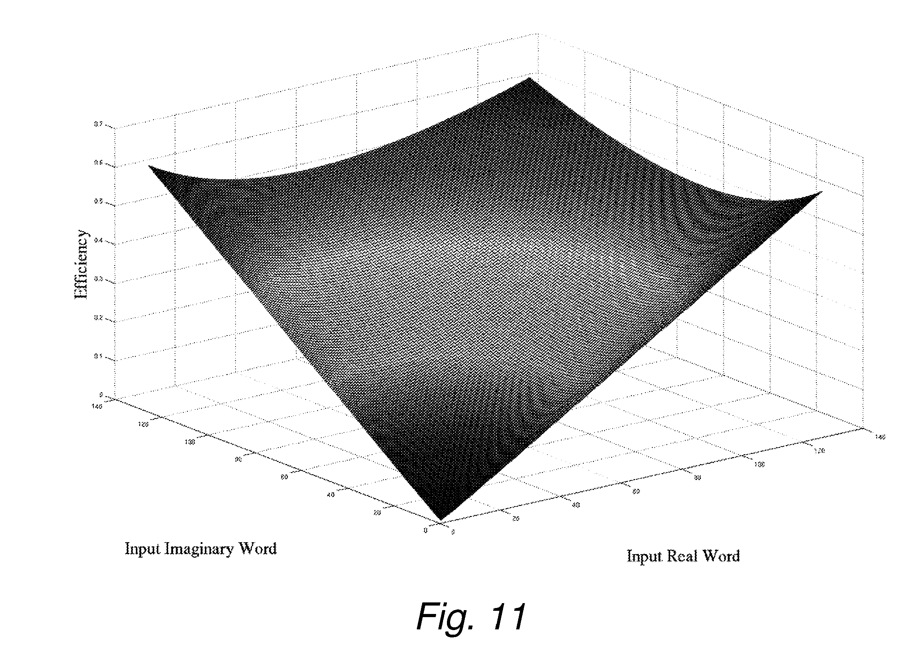

The efficiency in the complex domain can be obtained by substituting in equation (20) for a and b from 0 to N and the output is shown in Figure 11. Four phase I/Q as described above now also has better efficiency.
A FIR DDRM transmitter 1300 in accordance with the present invention is shown in Figure 12.
Digital I and Q signals 1310, 1315 are up-sampled in up-samplers 1320, 1325. The up-sampled signals 1330, 1335 form respective inputs to amplifier 1340, 1345. Signals 1330, 1335 are also supplied to an amplifier 1350, 1355 via delaying flip-flops 1360, 1365. LO signals 1370, 1375 are provided to the amplifiers 1340, 1345, 1350, 1355 as well. The outputs from the amplifiers 1340, 1350 are summed in summer 1380 for the I phase and outputs from amplifiers 1345, 1355 are summed in summer 1385 for the Q phase. The outputs from the summers 1380, 1385 are summed in a summer 1390 before being passed to an antenna 1395 for transmission.
The amplifiers 1340, 1345, 1350, 1355 correspond to two I/Q modulation DDRMs and the flip-flops 1360, 1365 form delays for subsequent DDRMs within the respective ones of the I and Q branch. In particular, for each extra DDRMs, an extra delaying flip flop will be necessary. Although only two DDRMs are shown, it will be appreciated that any number of DDRMs may be provided in accordance with the desired FIR filter shape with extra delaying flip flops being added as required.

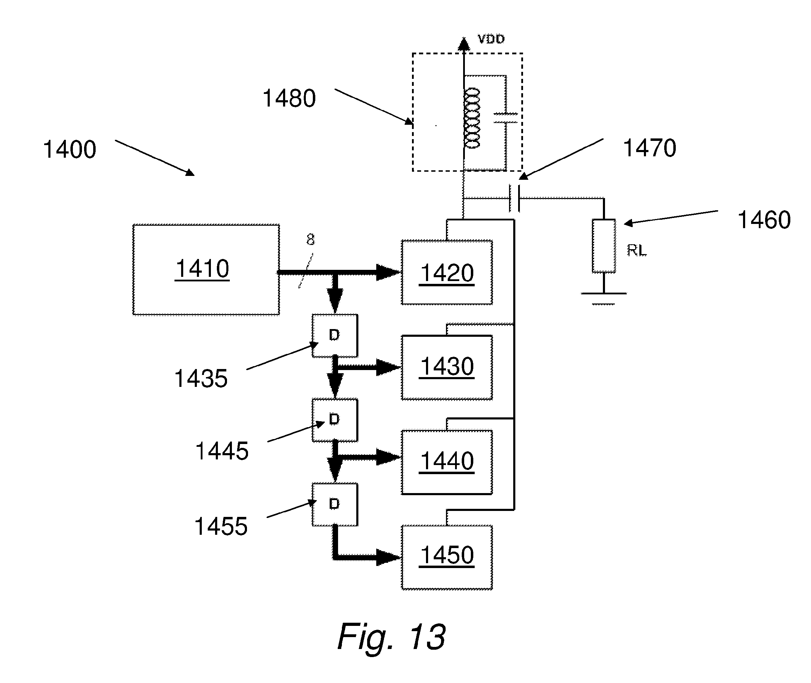

An example of a fourth-order FIR DDRM arrangement 1400 is shown in Figure 13. A digital signal processor (DSP) 1410 produces a signal that is input to a plurality of DDRMs 1420, 1430, 1440, 1450. The signal is input directly into the first DDRM 1420 and via delay units 1435, 1445, 1455 to respective ones of the subsequent DDRMs 1430, 1440, 1450. Each DDRM 1420, 1430, 1440, 1450 has a different gain value, a1, a2, a3, a4. The output from each DDRM 1420, 1430, 1440, 1450 is summed (not shown) and applied to a load 1460 via DC blocking capacitor 1470. Shorted harmonics filter 1480 is also included.

Although four DDRMs are shown and described with reference to Figure 12, it will be appreciated at least two DDRMs are required but any suitable number may be implemented.

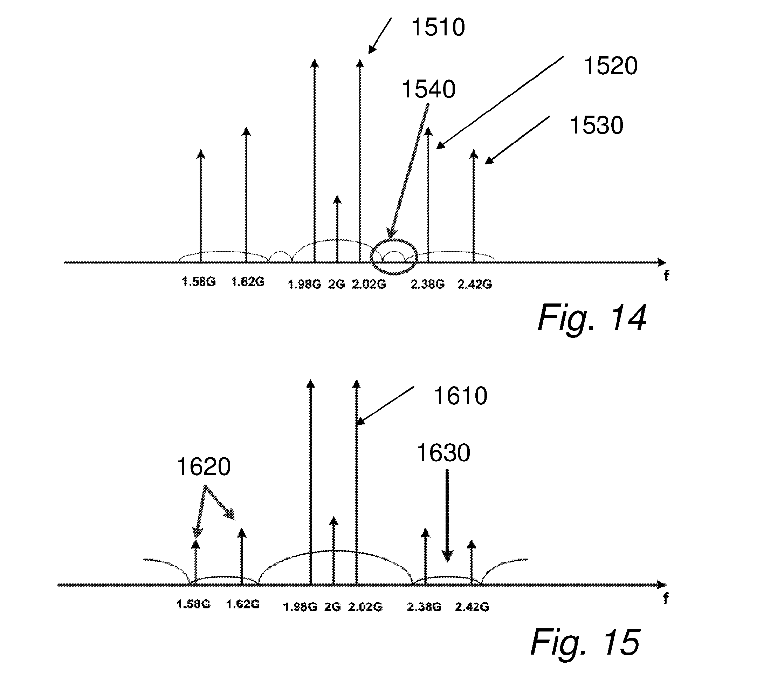

FIR transmitter spectra for delay values of $z^{-1}$ and $z^{-0.5}$ are shown in Figures 14 and 15 for a baseband signal at 20MHz modulated on a carrier frequency of 2GHz. In Figure 14, the transmitter signal 1510 is shown together with aliases 1520, 1530. The quantisation noise is shaped as shown at 1540. Similarly, in Figure 15, the transmitter signal 1610 is shown with reduced aliases 1620 and quantisation noise shaping 1630.

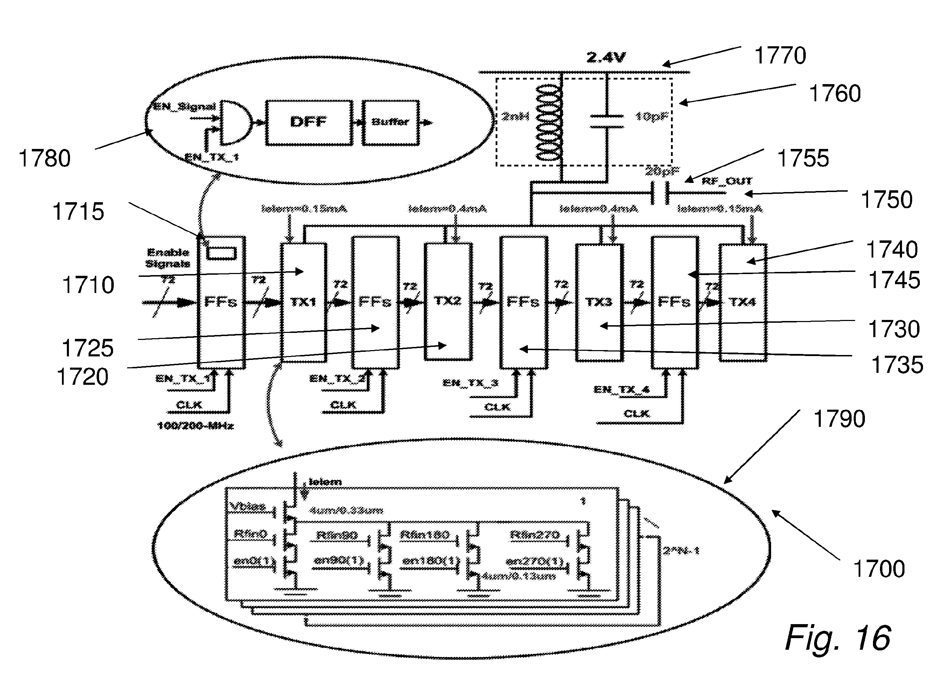

A prototype transmitter circuit 1700 is shown in Figure 16. The transmitter circuit 1700 operates on a carrier frequency of 1 GHz with a digital baseband data rate (sampling frequency) of 100MHz. An input data sampling frequency of 100MHz is used together with a fourth-order FIR filter. The maximum output power is 15dBm. A RF supply voltage of 2.4V is provided for the RF side together with a power supply of 1.2V for the remaining circuit.

The transmitter circuit 1700 comprises a FIR DDRM transmitter, a RF four-phase generator and a digital circuit to transform the digital input data into suitable enable signals. In the circuit 1700, four transmitter elements 1710, 1720, 1730, 1740 are shown connected to respective ones of a four phase input RF signals (not shown) and provide an RF output signal 1750 via a DC blocking capacitor 1755. Shorted harmonics filter 1760 is also provided as described above, and is connected between RF output 1750 and RF power supply 1770.

Each transmitter element 1710, 1720, 1730, 1740 is associated with a respective delay unit 1715, 1725, 1735, 1745. Enable signals are applied to each delay unit 1715, 1725, 1735, 1745. In addition, enable signals for each transmitter element 1710, 1720, 1730, 1740 and clock signals are also provided to each delay unit 1715, 1725, 1735, 1745. Modulator element currents, $I_{elem}$, are applied to each DDRM 1710, 1720, 1730, 1740 in accordance with FIR coefficients.

Each delay unit 1715, 1725, 1735, 1745 is implemented as shown by 1780 and comprises an AND gate, a delay flip-flop and a buffer. The two inputs to the AND gate comprise the enable signal and the transmitter enable signal.

Each DDRM 1710, 1720, 1730, 1740 comprises multiple modulator elements 1790 as described above with reference to Figure 9.

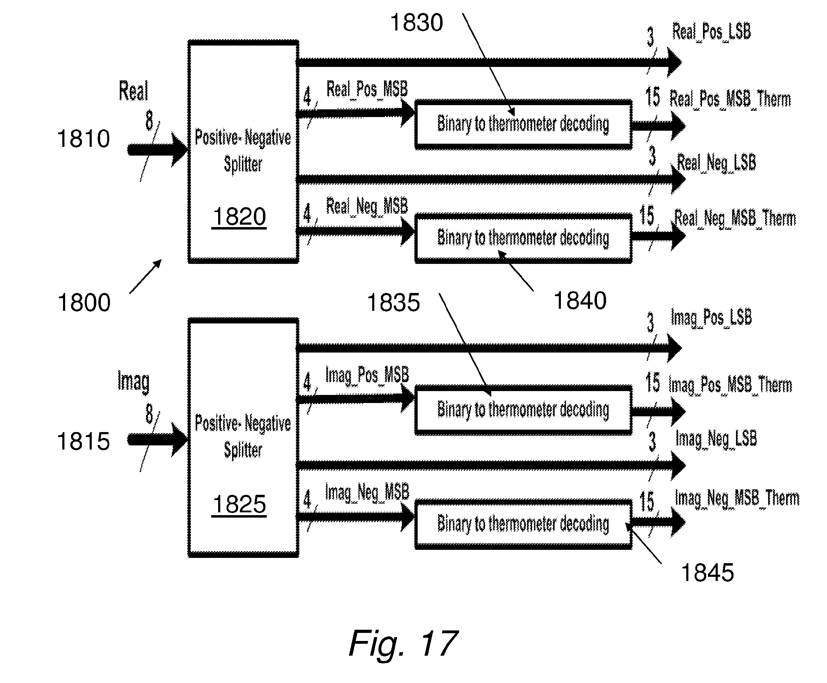

As shown, the circuit 1700 comprises four DDRMs. Each DDRM or transmitter element 1710, 1720, 1730, 1740 comprises 127 modulator elements ($2^7$-1). In each modulation element, upper transistor is a thick-gate transistor used to control the current of each transistor element, and hence to control the output power, and the FIR coefficients. It is chosen as a thick gate to increase the supply voltage to be 2.4V instead 1.2V, and hence quadrupling the maximum output power. The enable signals making the digital modulation are delayed by four banks of delay units 1715, 1725, 1735, 1745. Each delay unit contains AND gate to enable or disable the transmitter element, and a buffer to be able to switch subsequent transistor elements. As shown in Figure 17, two $V_{bias}$ signals are provided, one for the middle FIR coefficients and another for the outer FIR coefficients. By controlling the $V_{bias}$ signals, the FIR coefficients and the position of the filter notch can be adjusted so that the notch corresponds with the frequency band with the toughest noise requirements. This will mostly be the received band related to the transmit frequency.

For RF four-phase generation, two RF signals having 180° phase difference with 50% duty cycle form input signals for frequency division to generate four phases RF signals with 25% duty cycle. The RF signals are 2GHz square waves at 50% duty cycle with four output RF signals in quadrature as 1 GHz square waves at 25% duty cycle. After generation of the four RF signals from the two input signals, the four RF signals are buffered to drive the load capacitance. This load capacitance is the sum of parasitic capacitances of the RF switches of the FIR transmitter elements.

Digital decoding is used to decode the 16-bit input digital data to provide suitable enable signals for the FIR transmitter element to perform the digital modulation. The 16 bits consist of 8 bits for the real input part (I) and 8 bits for the imaginary input part (Q). This is shown in decoding circuit 1800 shown in Figure 17. Two 8-bit words 1810, 1815 are provided one for the real part and one for the imaginary part. These two words 1810, 1815 are applied to respective positive-negative splitters 1820, 1825 which generates two 7-bit words that control the digital modulation of the circuit. To reduce the complexity of the modulator and the interconnection, only 4 most significant bits (MSBs) are thermometer coded through the binary-to-thermometer decoding blocks 1830, 1840, 1835, 1845. The other 3 bits directly control binary scaled sections of the modulator. This gives a good compromise between circuit complexity and Differential non-linearity (DNL) and integral non-linearity (INL) of the DDRM.

Each binary-to-thermometer decoding block 1830, 1835, 1840, 1845 provides an output that corresponds to MSBs as shown. Only four MSBs are processed in the binary-to-thermometer decoding blocks 1830, 1835, 1840, 1845 to reduce connection complexity. Buffers (not shown) may be used after the decoding due to the long wiring to the FIR transmitter elements (not shown).

Each positive-negative splitter 1820, 1825 uses the MSB to determine the polarity of the current which is to be applied to the load, while the other bits are used to perform the digital modulation.

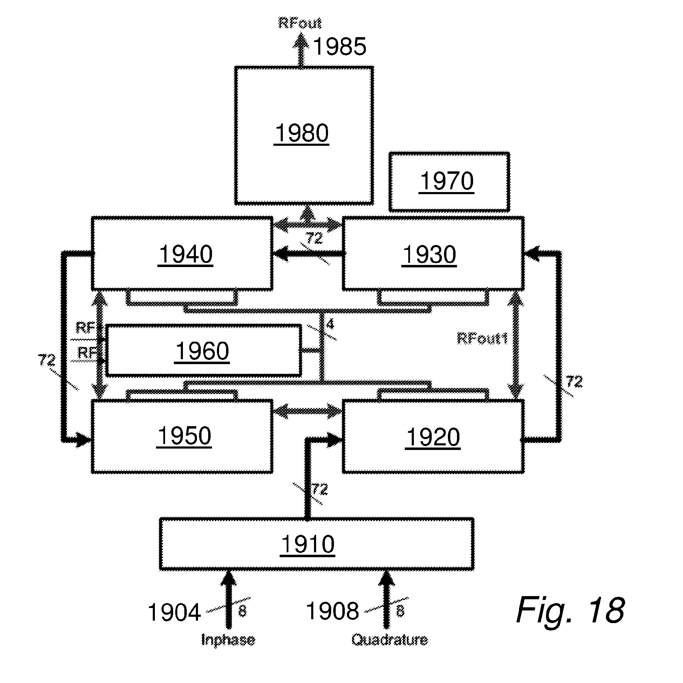

Figure 18 illustrates a possible chip layout 1900 for a DDRM with FIR notch filter arrangement in accordance with the present invention. Elements in the layout are arranged so that the distribution of the RF signals avoids delay inconsistencies, and the distance between different RF input signals is such that cross-talk is reduced.

The layout 1900 comprises a digital decoding unit 1910, four transmitter elements 1920, 1930, 1940, 1950, an RF 4-phase generator 1960 for generating a phase for each transmitter element 1920, 1930, 1940, 1950, current mirrors 1970 and an RF-choke tuning tank 1980. Input signals in-phase and quadrature signals 1904, 1908 are applied to the digital decoding unit 1910. Decoded signal 1915 is transmitted to transmitter elements 1920, 1930, 1940, 1950 in turn as shown. RF output signal 1985 is provided by RF-choke tuning tank 1980 as shown.

Although the layout 1900 shows a 4-phase generator, a multi-phase generator may also be used depending on the number of modulator elements provided. For example, the generator may be implemented by a multi-phase switch that switches in multiples of four, namely, four, eight etc.

As shown, the RF input lines to the transmitter elements 1920, 1930, 1940, 1950 are tree shaped. The lateral distance between the transmitter elements 1920, 1930, 1940, 1950 is reduced by placing the RF 4-phase generator 1960 in the middle to prevent RF lines from passing between transmitter element 1920 and transmitter element 1950 or between transmitter element 1930 and transmitter element 1940. RF output signal 1985 is located so to avoid any high series parasitic resistance that can reduce the efficiency of each transmitter element 1920, 1930, 1940, 1950.

Supply line, output line and ground line connections have low impedances and carry the large signal currents. Ground connections are made by four different bond pads to reduce the parasitic resistance and the inductance of the ground connection which absorb a lot of current. In addition, as shown in Figure 18, the RF output 1985 is arranged to be orthogonal to RF inputs to the RF generator 1960. This is to avoid any coupling between the inputs and the output.

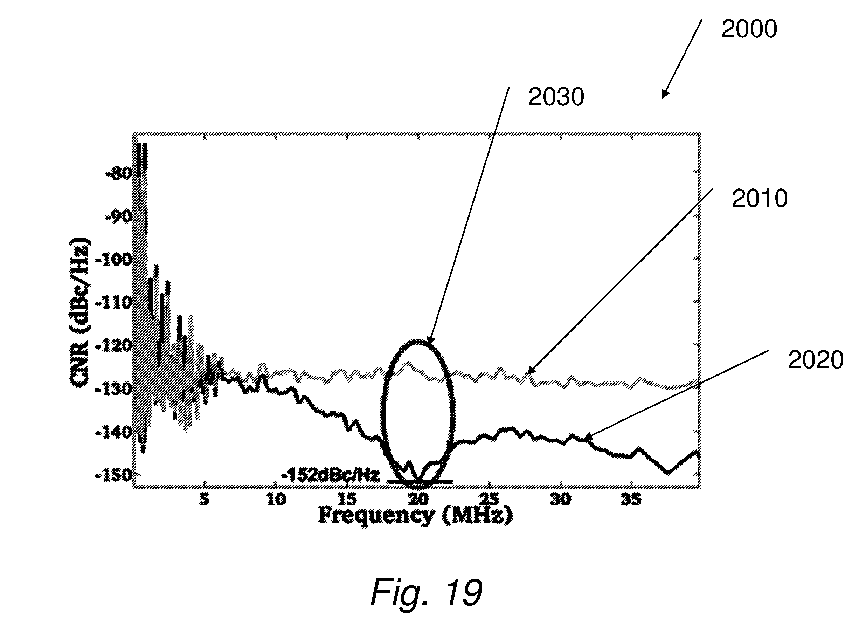

Four DDRMs are used to perform filtering and it is important to ensure that there is minimal mismatch between elements. A symmetrical layout is used to achieve high DNL and high INL. As thermometer bits increase the circuit complexity, a balance needs to be made between the performance and complexity. The four MSBs are transformed into thermometer (16-bits) and the three LSBs remain the same. Output buffers are provided by large transistors, due to the high load capacitance (all the modulation elements of the four transmitters). For a supply voltage of 1.2V, the ground connections need to be wide enough to carry this current. Further, there are two VDD bond pads to facilitate the flow of current. The power consumption of this circuit is critical, since it consumes a lot of power which reduces the overall system efficiency. For example, the maximum power of the circuit is 15dBm (31.6mW), and the 2.4V supply gives 21dBm (125mW) consumption power, so the drain efficiency is 25%. A measured spectrum 2000 obtained from the prototype transmitter is shown in Figure 19. Here, a noise floor comparison at 900MHz carrier frequency and 75MHz sampling frequency is shown together with a 200kHz baseband tone at maximum power, that is, -152dBc/Hz at 20MHz. Trace 2010 indicates the noise floor without FIR and trace 2020 indicates the noise floor with FIR in accordance with the present invention. The quantisation noise is clearly reduced at 20MHz offset, while the notch created by the FIR function is also clearly visible as indicated by 2030.

Whilst the present invention has been described with respect to specific embodiments, it will be appreciated that other embodiments are also possible.

## Claims

1. A radio frequency modulator (700; 1000) comprising:

   an input to which an input signal is applied;
   at least one modulator element (720, 722, 724, 726, 728; 1010, 1012, 1014, 1016, 1018) connected to the input and arranged for modulating the input signal to form a modulated output signal; and
   an output connected to each modulator element (720, 722, 724, 726, 728; 1010, 1012, 1014, 1016, 1018) and outputting the modulated output signal;
   **characterised in that** each modulator element (720, 722, 724, 726, 728; 1010, 1012, 1014, 1016, 1018) comprises a plurality of first switches (RFin0, RFin90, RFin180, RFin270), each first switch being switched in accordance with a multi-phase input signal to produce a modulated output signal.

2. A radio frequency modulator according to claim 1, wherein each modulator element (1010, 1012, 1014, 1016, 1018) further comprises a plurality of second switches (en0(1), en90(1), en 180(1), en270(1)) for providing enable signals that operate in conjunction with the plurality of the first switches (RFin0, RFin90, RFin180, RFin270) to produce the modulated output signal, each phase of the multi-phase input signal having a first switch and a second switch associated therewith.

3.  A radio frequency modulator according to claim 1 or 2, wherein each modulator element (720, 722, 724, 726, 728; 1010, 1012, 1014, 1016, 1018) further comprises a bias control (730; 1050) for controlling the output signal produced by the modulator element (720, 722, 724, 726, 728; 1010, 1012, 1014, 1016, 1018).

4.  A radio frequency modulator according to any one of the preceding claims, wherein the multi-phase input signal comprises a four-phase phase input signal.

5.  A radio frequency modulator according to any one of the preceding claims, wherein a plurality of modulator elements (720, 722, 724, 726, 728; 1010, 1012, 1014, 1016, 1018) are provided and the modulated output signal produced by each modulator element (720, 722, 724, 726, 728; 1010, 1012, 1014, 1016, 1018) is summed to form the output modulated signal.

6.  A radio frequency transmitter comprising at least one radio frequency modulator according to any one of the preceding claims, and wherein the modulator elements (720, 722, 724, 726, 728; 1010, 1012, 1014, 1016, 1018) together form at least one finite impulse response filter.

7.  A radio frequency transmitter according to claim 6, further comprising a plurality of radio frequency modulators, and a delay circuit (1435, 1445, 1455; 1715, 1725, 1735, 1745) for each radio frequency modulator after the first, an enable signal being provided for a subsequent radio frequency modulator (1430, 1440, 1450; 1710, 1720, 1730, 1740; 1920, 1930, 1940, 1950) through its associated delay circuit (1435, 1445, 1455; 1715, 1725, 1735, 1745).

8.  A radio frequency transmitter according to claim 6 or 7, wherein at least two radio frequency modulators (1710, 1720, 1730, 1740; 1920, 1930, 1940, 1950) are provided and each bias control (1050) operates in accordance with finite impulse response coefficients.

9.  A radio frequency transmitter according to claim 8, further comprising a radio frequency multi-phase generator.

10. A radio frequency transmitter according to claim 8 or 9, wherein four radio frequency modulators (1710, 1720, 1730, 1740; 1920, 1930, 1940, 1950) are provided.

11. A radio frequency transmitter according to claim 10, further comprising a radio frequency four phase generator.

12. A radio frequency transmitter according to any one of claims 6 to 11, further comprising a decoding circuit (1910) for decoding input signals (1904, 1908).

13. A radio frequency transmitter according to claim 12, wherein the decoding circuit (1910) decodes input in-phase and quadrature-phase signals (1904, 1908).

*Fig. 1*

EP 2 541 776 A1

*Fig. 2*

EP 2 541 776 A1

*Fig. 3*

*Fig. 4*

*Fig. 5*

Fig. 6

Fig. 7

EP 2 541 776 A1

$$Z_1 = R_L + j\left(\frac{I_2}{I_1}\right) * R_L$$

$$Z_2 = R_L - j\left(\frac{I_1}{I_2}\right) * R_L$$

*Fig. 8*

EP 2 541 776 A1

*Fig. 9*

EP 2 541 776 A1

Fig. 10

EP 2 541 776 A1

*Fig. 11*

Fig. 12

*Fig. 13*

EP 2 541 776 A1

*Fig. 14*

*Fig. 15*

Fig. 16

Fig. 17

*Fig. 17*

Fig. 18

*Fig. 19*

Europäisches
Patentamt
European
Patent Office
Office européen
des brevets

**EUROPEAN SEARCH REPORT**

Application Number

EP 11 17 1905

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 2 037 584 A1 (ST MICROELECTRONICS NV [NL]; ST MICROELECTRONICS SA [FR]) 18 March 2009 (2009-03-18) | 1-5 | INV. H03M1/74 H04L27/36 |
| Y | * the whole document * ----- | 6-13 | |
| X | WO 2006/117590 A1 (NOKIA CORP [FI]; NOKIA INC [US]; SHAKESHAFT NIALL E [FI]; VEPSAELAEINE) 9 November 2006 (2006-11-09) | 1-5 | |
| Y | * page 1, lines 27-33; figures 5-11 * * page 5, line 5 - page 6, line 21 * * page 9, line 7 - page 13, line 7 * ----- | 6-13 | |
| Y | TALEIE S M ET AL: "A Bandpass /spl Delta//spl Sigma/ RF-DAC with Embedded FIR Reconstruction Filter", DIGEST OF TECHNICAL PAPERS / 2006 IEEE INTERNATIONAL SOLID-STATE CIRCUITS CONFERENCE : SAN FRANCISCO, CA, 5 - 9 FEBRUARY 2006, IEEE SERVICE CENTER, PISCATAWAY, NJ , US, 6 February 2006 (2006-02-06), pages 2370-2379, XP010940644, DOI: 10.1109/ISSCC.2006.1696300 ISBN: 978-1-4244-0079-9 * figures 31.7.1, 31.7.2 * ----- | 6-13 | |

TECHNICAL FIELDS
SEARCHED (IPC)

H03M
H04L
H03F
H04B

-/--

The present search report has been drawn up for all claims

| Place of search | Date of completion of the search | Examiner |
|---|---|---|
| Munich | 20 January 2012 | Brosa, Anna-Maria |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

Europäisches
Patentamt

European
Patent Office

Office européen
des brevets

**EUROPEAN SEARCH REPORT**

Application Number

EP 11 17 1905

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | SHAHIN MEHDIZAD TALEIE ET AL: "A Linear â Digital IF to RF DAC Transmitter With Embedded Mixer", IEEE TRANSACTIONS ON MICROWAVE THEORY AND TECHNIQUES, IEEE SERVICE CENTER, PISCATAWAY, NJ, US, vol. 55, no. 5, 1 May 2008 (2008-05-01), pages 1059-1068, XP011206782, ISSN: 0018-9480 * abstract; figures 4, 5, 9, 10 * * page 1063, right-hand column, paragraph 3 - page 1065, left-hand column, paragraph 2 * ----- | 6-13 | |
| Y,D | US 7 528 754 B1 (BAKKALOGLU BERTAN [US] ET AL) 5 May 2009 (2009-05-05) * the whole document * ----- | 6-13 | |

TECHNICAL FIELDS
SEARCHED    (IPC)

The present search report has been drawn up for all claims

| Place of search | Date of completion of the search | Examiner |
|---|---|---|
| Munich | 20 January 2012 | Brosa, Anna-Maria |

EPO FORM 1503 03.82 (P04C01)

**ANNEX TO THE EUROPEAN SEARCH REPORT
ON EUROPEAN PATENT APPLICATION NO.**                     EP 11 17 1905

This annex lists the patent family members relating to the patent documents cited in the above-mentioned European search report.
The members are as contained in the European Patent Office EDP file on
The European Patent Office is in no way liable for these particulars which are merely given for the purpose of information.

20-01-2012

| Patent document cited in search report | | Publication date | Patent family member(s) | | Publication date |
|---|---|---|---|---|---|
| EP 2037584 | A1 | 18-03-2009 | EP 2037584 A1 | | 18-03-2009 |
| | | | US 2009073013 A1 | | 19-03-2009 |
| WO 2006117590 | A1 | 09-11-2006 | AT 437511 T | | 15-08-2009 |
| | | | CN 101164310 A | | 16-04-2008 |
| | | | EP 1875700 A1 | | 09-01-2008 |
| | | | KR 20070119045 A | | 18-12-2007 |
| | | | WO 2006117590 A1 | | 09-11-2006 |
| US 7528754 | B1 | 05-05-2009 | NONE | | |

EPO FORM P0459

For more details about this annex : see Official Journal of the European Patent Office, No. 12/82

**EP 2 541 776 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 7528754 B